# EUROPEAN PATENT APPLICATION

(11) **EP 4 213 387 A1**
(43) Date of publication of application: **19.07.2023**
(21) Application number: 22212108.9
(22) Date of filing: 08.12.2022
(51) Int. Cl.: H03K 19/0185, H04L 25/02

(54) **HIGH BANDWIDTH AND LOW POWER TRANSMITTER**

(30) Priority: 14.01.2022 US 202263299421 P; 16.11.2022 US 202217987875
(71) Applicant: MediaTek Inc., Hsin-Chu 300 (TW)
(72) Inventor: LEE, Fong-Wen, 30078 Hsinchu City (TW); WANG, Wen-Chieh, 30078 Hsinchu City (TW); LIN, Yu-Hsin, 30078 Hsinchu City (TW)
(74) Representative: Haseltine Lake Kempner LLP

(57) **Abstract**

The present invention provides a transmitter (100, 300) including a first variable resistor (RB1), a first transistor (M1), a second transistor (M2), a third transistor (M3) and a fourth transistor (M4) is disclosed. The first variable resistor (RB1) is coupled between a supply voltage (VDD) and a first node (N1). A first electrode of the first transistor is coupled to the first node, and a second electrode of the first transistor is coupled to a first output terminal (No1) of the transmitter. A first electrode of the second transistor is coupled to the first output terminal of the transmitter, and a second electrode of the second transistor is coupled to a second node (N2). A first electrode of the third/fourth transistor is coupled to the first node, and a second electrode of the third/fourth transistor is coupled to a second output terminal (No2) of the transmitter.

## Description

This application claims the benefit of U.S. Provisional Application No. 63/299,421, filed on January 14th, 2022. The content of the application is incorporated herein by reference.

### Background

In a conventional transmitter, a variable resistor is generally designed at an output terminal of the transmitter for impedance matching, wherein the variable resistor is implemented by a resistor bank comprising a plurality of switched-resistors connected in parallel. However, the switches in the variable resistor have high parasitic capacitance, so the output terminal of the transmitter also has high parasitic capacitance, which degrades a bandwidth of the transmitter.

### Summary

It is therefore an objective of the present invention to provide a transmitter with variable resistor, which has small parasitic capacitance at the output terminal, to solve the above-mentioned problems.

According to one embodiment of the present invention, a transmitter comprising a first variable resistor, a first transistor, a second transistor, a third transistor and a fourth transistor is disclosed. The first variable resistor is coupled between a supply voltage and a first node. A first electrode of the first transistor is coupled to the first node, and a second electrode of the first transistor is coupled to a first output terminal of the transmitter. A first electrode of the second transistor is coupled to the first output terminal of the transmitter, and a second electrode of the second transistor is coupled to a second node. A first electrode of the third transistor is coupled to the first node, and a second electrode of the third transistor is coupled to a second output terminal of the transmitter. A first electrode of the fourth transistor is coupled to the second output terminal of the transmitter, and a second electrode of the fourth transistor is coupled to the second node. The transmitter receives a first input signal and a second input signal at gate electrodes of the first transistor, the second transistor, the third transistor and the fourth transistor, respectively, to generate a first output signal and a second output signal at the first output terminal and the second output terminal, respectively.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a diagram illustrating a transmitter according to one embodiment of the present invention.
FIG. 2 is a diagram illustrating a variable resistor according to one embodiment of the present invention.
FIG. 3 is a diagram illustrating a transmitter according to one embodiment of the present invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

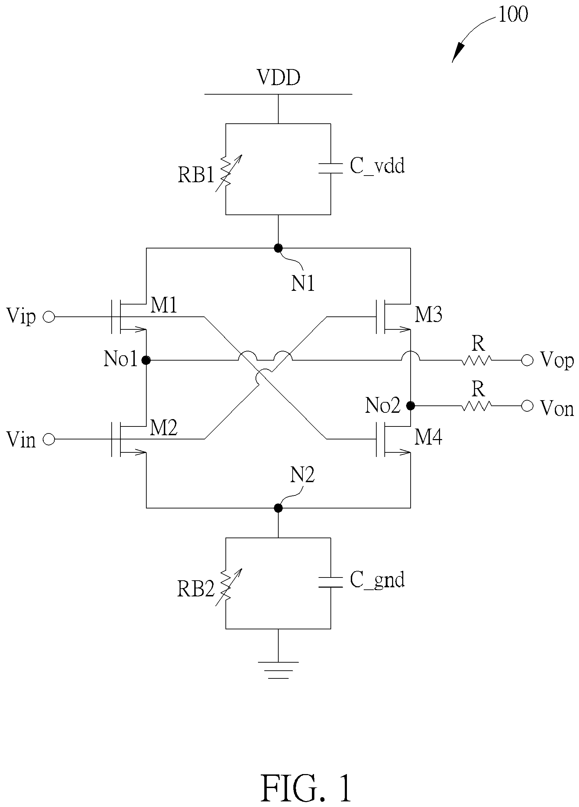

FIG. 1 is a diagram illustrating a transmitter 100 according to one embodiment of the present invention. As shown in FIG. 1, the transmitter 100 comprises transistors M1 - M4, a variable resistor RB1, a variable resistor RB2, a capacitor C_vdd, a capacitor C_gnd and two resistors R. In this embodiment, the variable resistor RB1 is coupled between a supply voltage VDD and a node N1, wherein the node N1 is coupled to a first electrode of the transistor M1 and a first electrode of the transistor M3. A second electrode of the transistor M1 is coupled to a first output terminal No1 of the transmitter 100, and a second electrode of the transistor M3 is coupled to a second output terminal No2 of the transmitter 100. A first electrode of the transistor M2 is coupled to the first output terminal No1 of the transmitter 100, and a first electrode of the transistor M4 is coupled to the second output terminal No2 of the transmitter 100. The variable resistor RB2 is coupled between a ground voltage and a node N2, wherein the node N2 is coupled to a second electrode of the transistor M2 and a second electrode of the transistor M4. In this embodiment, each of the transistors M1 - M4 is an N-type Metal-Oxide-Semiconductor (NMOS), and the transmitter 100 can be used in any appropriate serializer/deserializer circuitry.

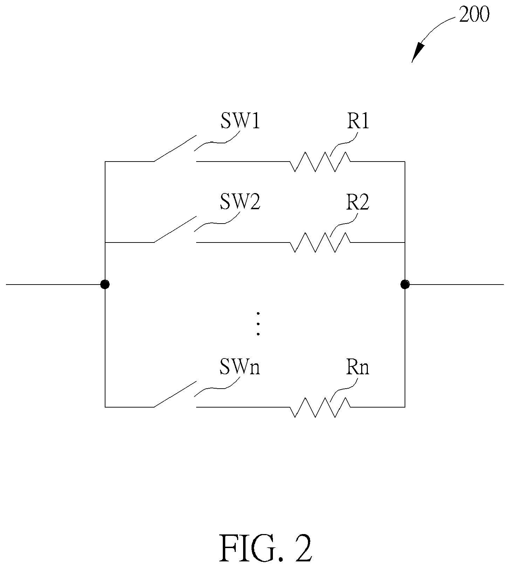

FIG. 2 is a diagram illustrating a variable resistor 200 according to one embodiment of the present invention, wherein the variable resistor 200 can be used to implement the variable resistor RB1 and/or the variable resistor RB2. As shown in FIG. 2, the variable resistor 200 comprises a plurality of switches SW1 - SWn and a plurality of resistors R1 - Rn, wherein one switch and one resistor can be regarded as a switched-resistor (e.g., SW1 and R1), and the plurality of switched-resistor are connected in parallel. The variable resistor 200 can be controlled to have different resistance by enabling or disabling at least part of the switches SW1 - SWn.

The transmitter 100 is configured to receive a first input signal Vip and a second input signal Vin to generate a first output signal Vop and a second output signal Von via the resistors R. Specifically, the first input signal Vip and the second input signal Vin are a differential input signal, the first input signal Vip is inputted into gate electrodes of the transistors M1 and M4, and the second input signal Vin is inputted into gate electrodes of the transistors M2 and M3. When the first input signal Vip has a high voltage level (i.e., logical value "1") while the second input signal Vin has a low voltage level (i.e., logical value "0"), the transistors M1 and M4 are enabled and the transistors M2 and M3 are disabled, so that the first output signal Vop has high voltage level and the second output signal Von has low voltage level. Similarly, when the first input signal Vip has the low voltage level while the second input signal Vin has the high voltage level, the transistors M1 and M4 are disabled and the transistors M2 and M3 are enabled, so that the first output signal Vop has low voltage level and the second output signal Von has high voltage level.

In the operation of the transmitter 100, because the transistors M1 and M3 are alternately enabled due to the differential input signal, the current flowing from the supply voltage VDD and the variable resistor RB1 to the node N1 should be always the same (it is assumed that the current flowing through the transistor M1 and the current flowing through the transistor M3 are substantially the same), and the voltage level of the node N1 can be regarded as a constant. Specifically, when the first input signal Vip has the high voltage level while the second input signal Vin has the low voltage level, the current path is from the supply voltage VDD, the variable resistor RB1, the node N1, the transistor M1 to the first output terminal No1; and when the first input signal Vip has the low voltage level while the second input signal Vin has the high voltage level, the current path is from the supply voltage VDD, the variable resistor RB1, the node N1, the transistor M3 to the second output terminal No2. Therefore, since the node N1 always has a constant voltage level, it means that the node N1 will not be charged or discharged, so the high parasitic capacitance of the variable resistor RB1 will not affect waveform of any one of the first output signal Vop and the second output signal Von, that is the bandwidth of the transmitter 100 will not be influenced due to the high parasitic capacitance of the variable resistor RB1.

Similarly, because the transistors M2 and M4 are alternately enabled due to the differential input signal, the current flowing from the node N2 to the ground voltage via the variable resistor RB2 should be always the same (it is assumed that the current flowing through the transistor M2 and the current flowing through the transistor M4 are substantially the same), and the voltage level of the node N2 can be regarded as a constant. Specifically, when the first input signal Vip has the high voltage level while the second input signal Vin has the low voltage level, the current path is from the second output terminal No2, the transistor M4, the node N2, the variable resistor RB2 to the ground voltage; and when the first input signal Vip has the low voltage level while the second input signal Vin has the high voltage level, the current path is from the first output terminal No1, the transistor M2, the node N2, the variable resistor RB2 to the ground voltage. Therefore, since the node N2 always has a constant voltage level, it means that the node N2 will not be charged or discharged, so the high parasitic capacitance of the variable resistor RB2 will not affect waveform of any signal related to the first output signal Vop and the second output signal Von, that is the bandwidth of the transmitter 100 will not be influenced due to the high parasitic capacitance of the variable resistor RB2.

In light of above, by designing the variable resistor RB1 between the supply voltage VDD and the node N1 and/or designing the variable resistor RB2 between the ground voltage and the node N2 for impedance matching, the transmitter 100 does not need to have variable resistors at the output terminals, that is signals at the first output terminal No1 and the second output terminal No2 will not be influenced by high parasitic capacitance, and the bandwidth of the transmitter 100 will not be worsened due to the design of the variable resistors.

In addition, the capacitor C_vdd and the capacitor C_gnd are used to provide low impedance at high frequency, and the capacitor C_vdd and the capacitor C_gnd can be removed from FIG. 1 without affecting normal operations of the transmitter 100.

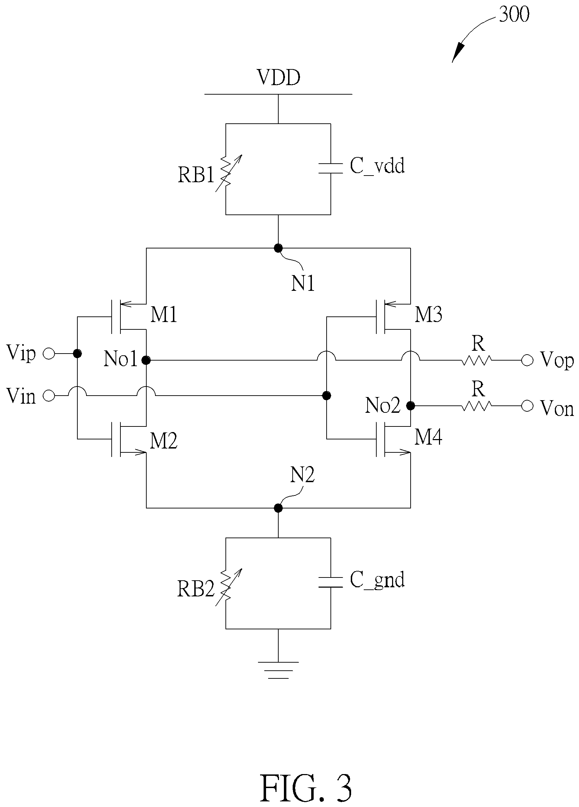

FIG. 3 is a diagram illustrating a transmitter 300 according to one embodiment of the present invention. As shown in FIG. 3, the transmitter 300 comprises transistors M1 - M4, a variable resistor RB1, a variable resistor RB2, a capacitor C_vdd, a capacitor C_gnd and two resistors R. In this embodiment, the variable resistor RB1 is coupled between a supply voltage VDD and a node N1, wherein the node N1 is coupled to a first electrode of the transistor M1 and a first electrode of the transistor M3. A second electrode of the transistor M1 is coupled to a first output terminal No1 of the transmitter 300, and a second electrode of the transistor M3 is coupled to a second output terminal No2 of the transmitter 300. A first electrode of the transistor M2 is coupled to the first output terminal No1 of the transmitter 300, and a first electrode of the transistor M4 is coupled to the second output terminal No2 of the transmitter 300. The variable resistor RB2 is coupled between a ground voltage and a node N2, wherein the node N2 is coupled to a second electrode of the transistor M2 and a second electrode of the transistor M4. In this embodiment, the transistors M1 and M3 are implemented by PMOS, the transistors M2 and M2 are implemented by NMOS, the transmitter 300 can be used in any appropriate serializer/deserializer circuitry.

The variable resistor RB1 and/or the variable resistor RB2 shown in FIG. 3 can be implemented by the variable resistor 200.

The transmitter 300 is configured to receive a first input signal Vip and a second input signal Vin to generate a first output signal Vop and a second output signal Von via the resistors R. Specifically, the first input signal Vip and the second input signal Vin are a differential input signal, the first input signal Vip is inputted into gate electrodes of the transistors M1 and M2, and the second input signal Vin is inputted into gate electrodes of the transistors M3 and M4. When the first input signal Vip has a high voltage level (i.e., logical value "1") while the second input signal Vin has a low voltage level (i.e., logical value "0"), the transistors M1 and M4 are disabled and the transistors M2 and M3 are disabled, so that the first output signal Vop has low voltage level and the second output signal Von has high voltage level. Similarly, when the first input signal Vip has the low voltage level while the second input signal Vin has the high voltage level, the transistors M1 and M4 are enabled and the transistors M2 and M3 are disabled, so that the first output signal Vop has high voltage level and the second output signal Von has low voltage level.

In the operation of the transmitter 300, because the transistors M1 and M3 are alternately enabled due to the differential input signal, the current flowing from the supply voltage VDD and the variable resistor RB1 to the node N1 should be always the same (it is assumed that the current flowing through the transistor M1 and the current flowing through the transistor M3 are substantially the same), and the voltage level of the node N1 can be regarded as a constant. Specifically, when the first input signal Vip has the low voltage level while the second input signal Vin has the high voltage level, the current path is from the supply voltage VDD, the variable resistor RB1, the node N1, the transistor M1 to the first output terminal No1; and when the first input signal Vip has the high voltage level while the second input signal Vin has the low voltage level, the current path is from the supply voltage VDD, the variable resistor RB1, the node N1, the transistor M3 to the second output terminal No2. Therefore, since the node N1 always has a constant voltage level, it means that the node N1 will not be charged or discharged, so the high parasitic capacitance of the variable resistor RB1 will not affect waveform of any one of the first output signal Vop and the second output signal Von, that is the bandwidth of the transmitter 300 will not be influenced due to the high parasitic capacitance of the variable resistor RB1.

Similarly, because the transistors M2 and M4 are alternately enabled due to the differential input signal, the current flowing from the node N2 to the ground voltage via the variable resistor RB2 should be always the same (it is assumed that the current flowing through the transistor M2 and the current flowing through the transistor M4 are substantially the same), and the voltage level of the node N2 can be regarded as a constant. Specifically, when the first input signal Vip has the low voltage level while the second input signal Vin has the high voltage level, the current path is from the second output terminal No2, the transistor M4, the node N2, the variable resistor RB2 to the ground voltage; and when the first input signal Vip has the high voltage level while the second input signal Vin has the low voltage level, the current path is from the first output terminal No1, the transistor M2, the node N2, the variable resistor RB2 to the ground voltage. Therefore, since the node N2 always has a constant voltage level, it means that the node N2 will not be charged or discharged, so the high parasitic capacitance of the variable resistor RB2 will not affect waveform of any one of the first output signal Vop and the second output signal Von, that is the bandwidth of the transmitter 300 will not be influenced due to the high parasitic capacitance of the variable resistor RB2.

In light of above, by designing the variable resistor RB1 between the supply voltage VDD and the node N1 and/or designing the variable resistor RB2 between the ground voltage and the node N2 for impedance matching, the transmitter 300 does not need to have variable resistors at the output terminals, that is signals at the first output terminal No1 and the second output terminal No2 will not be influenced by high parasitic capacitance, and the bandwidth of the transmitter 300 will not be worsened due to the design of the variable resistors.

In addition, the capacitor C_vdd and the capacitor C_gnd are used to provide low impedance at high frequency, and the capacitor C_vdd and the capacitor C_gnd can be removed from FIG. 3 without affecting normal operations of the transmitter 300.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A transmitter (100, 300), comprising:
a first variable resistor (200) coupled between a supply voltage and a first node;
a first transistor (M1), wherein a first electrode of the first transistor (M1) is coupled to the first node, and a second electrode of the first transistor (M1) is coupled to a first output terminal of the transmitter (100, 300);
a second transistor (M2), wherein a first electrode of the second transistor (M2) is coupled to the first output terminal of the transmitter (100, 300), and a second electrode of the second transistor (M2) is coupled to a second node;
a third transistor (M3), wherein a first electrode of the third transistor (M3) is coupled to the first node, and a second electrode of the third transistor (M3) is coupled to a second output terminal of the transmitter (100, 300); and
a fourth transistor (M4), wherein a first electrode of the fourth transistor (M4) is coupled to the second output terminal of the transmitter (100, 300), and a second electrode of the fourth transistor (M4) is coupled to the second node;
wherein the transmitter (100, 300) receives a first input signal and a second input signal at gate electrodes of the first transistor(M1), the second transistor (M2), the third transistor (M3) and the fourth transistor (M4), respectively, to generate a first output signal and a second output signal at the first output terminal and the second output terminal, respectively.

2. The transmitter (100, 300) of claim 1, wherein the first input signal and the second input signal are a differential input signal, the first transistor (M1) and the fourth transistor (M4) are controlled to be enabled while the second transistor (M2) and the third transistor (M3) are controlled to be disabled, and the first transistor (M1) and the fourth transistor (M4) are controlled to be disabled while the second transistor (M2) and the third transistor (M3) are controlled to be enabled.

3. The transmitter (100, 300) of claim 2, wherein the first transistor (M1) and the third transistor (M3) are alternately enabled so that a current flowing through the first node is substantially the same whether the first transistor (M1) is enabled or the third transistor (M3) is enabled.

4. The transmitter (100, 300) of claim 1, further comprising:
a second variable resistor (200), coupled between a ground voltage and the second node.

5. The transmitter (100, 300) of claim 4, wherein the first input signal and the second input signal are a differential input signal, the first transistor (M1) and the fourth transistor (M4) are controlled to be enabled while the second transistor (M2) and the third transistor (M3) are controlled to be disabled, and the first transistor (M1) and the fourth transistor (M4) are controlled to be disabled while the second transistor (M2) and the third transistor (M3) are controlled to be enabled; and the first transistor (M1) and the third transistor (M3) are alternately enabled so that a current flowing through the first node is substantially the same whether the first transistor (M1) is enabled or the third transistor (M3) is enabled, and the second transistor (M2) and the fourth transistor (M4) are alternately enabled so that a current flowing through the second node is substantially the same whether the second transistor (M2) is enabled or the fourth transistor (M4) is enabled.

6. The transmitter (100, 300) of claim 1, wherein the first variable resistor (200) and the second variable resistor (200) are used for impedance matching of the transmitter (100, 300), and there is no variable resistor (200) directly connected to the first output terminal and the second output terminal of the transmitter (100, 300).

7. The transmitter (100, 300) of claim 1, wherein each of the first transistor (M1), the second transistor (M2), the third transistor (M3) and the fourth transistor (M4) is an N-type transistor, the first input signal and the second input signal are a differential input signal, the first input signal is inputted into the gate electrodes of the first transistor (M1) and the fourth transistor (M4), and the second input signal is inputted into the gate electrodes of the second transistor (M2) and the third transistor (M3) .

8. The transmitter (100, 300) of claim 7, wherein the first transistor (M1) and the third transistor (M3) are alternately enabled so that a current flowing through the first node is substantially the same whether the first transistor (M1) is enabled or the third transistor (M3) is enabled.

9. The transmitter (100, 300) of claim 7, further comprising:
a second variable resistor (200), coupled between a ground voltage and the second node;
wherein the first transistor (M1) and the third transistor (M3) are alternately enabled so that a current flowing through the first node is substantially the same whether the first transistor (M1) is enabled or the third transistor (M3) is enabled; and the second transistor (M2) and the fourth transistor (M4) are alternately enabled so that a current flowing through the second node is substantially the same whether the second transistor (M2) is enabled or the fourth transistor (M4) is enabled.

10. The transmitter (100, 300) of claim 1, wherein each of the first transistor (M1) and the third transistor (M3) is a P-type transistor, each of the second transistor (M2) and the fourth transistor (M4) is an N-type transistor, the first input signal and the second input signal are a differential input signal, the first input signal is inputted into the gate electrodes of the first transistor (M1) and the second transistor (M2), and the second input signal is inputted into the gate electrodes of the third transistor (M3) and the fourth transistor (M4).

11. The transmitter (100, 300) of claim 10, wherein the first transistor (M1) and the third transistor (M3) are alternately enabled so that a current flowing through the first node is substantially the same whether the first transistor (M1) is enabled or the third transistor (M3) is enabled.

12. The transmitter (100, 300) of claim 10, further comprising:
a second variable resistor (200), coupled between a ground voltage and the second node;
wherein the first transistor (M1) and the third transistor (M3) are alternately enabled so that a current flowing through the first node is substantially the same whether the first transistor (M1) is enabled or the third transistor (M3) is enabled; and the second transistor (M2) and the fourth transistor (M4) are alternately enabled so that a current flowing through the second node is substantially the same whether the second transistor (M2) is enabled or the fourth transistor (M4) is enabled.
